# EUROPÄISCHE PATENTSCHRIFT

(11) **EP 2 042 801 B1**
(45) Veröffentlichungstag und Bekanntmachung des Hinweises auf die Patenterteilung: **02.11.2016**
(21) Anmeldenummer: 08164438.7
(22) Anmeldetag: 16.09.2008
(51) Int. Cl.: F21V 3/04, F21V 31/04, F21V 5/00, F21V 9/16, F21V 13/02, F21V 15/01, F21Y 103/00, F21K 99/00, F21S 8/10, H01L 25/075, H01L 25/16, H01L 33/58

(54) **Lichtquelle mit veränderlicher Abstrahlcharakteristik**
Light source with adjustable emission characteristics
Source lumineuse dotée de caractéristiques d'émission modifiables

(30) Priorität: 27.09.2007 DE 102007046339
(43) Veröffentlichungstag der Anmeldung: 01.04.2009
(73) Patentinhaber: OSRAM Opto Semiconductors GmbH, 93055 Regensburg (DE)
(72) Erfinder: Wilm, Alexander, 93059, Regensburg (DE)
(74) Vertreter: Epping - Hermann - Fischer

(56) Entgegenhaltungen:
- DE-A1- 10 044 455
- DE-U1-202007 001 148
- US-A1- 2004 179 368
- US-A1- 2005 157 508
- US-A1- 2006 022 211

## Beschreibung

Die vorliegende Erfindung betrifft eine Lichtquelle, die aus Leuchtdioden aufgebaut ist und deren Abstrahlcharakteristik verändert werden kann. Insbesondere ist diese Vorrichtung als Autoscheinwerfer mit dynamischem Kurvenlicht geeignet.

Es ist oftmals erforderlich, die Abstrahlrichtung einer Lichtquelle, deren Licht in einen begrenzten Raumwinkelbereich gebündelt ist, wie zum Beispiel bei Schweinwerfern, während des Betriebs der Lichtquelle zu verändern. Das ist insbesondere bei Automobilscheinwerfern von Interesse, wenn bei einer Kurvenfahrt die Strahlrichtung der Scheinwerfer als so genanntes dynamisches Kurvenlicht der jeweiligen Fahrtrichtung nachgeführt werden soll. Derartige Scheinwerfervorrichtungen sind insbesondere durch die Modellreihe Citroen DS bekannt geworden. Aber bereits sehr viel früher hat es drehbare Scheinwerferbefestigungen gegeben, die mit der Steuerung mechanisch verbunden waren, so dass die Scheinwerfer beim Lenken zusammen mit den Vorderrädern geschwenkt wurden.

Mit dem Aufkommen der Verwendung von Leuchtdioden (LEDs) für Scheinwerfer ist auch das Interesse an einem dynamischen Kurvenlicht, jetzt als AFS (advanced front-lighting systems) bezeichnet, wieder erwacht. Mit dem AFS soll nicht nur erreicht werden, dass bei einer Kurvenfahrt die Fahrbahn in der jeweiligen Fahrtrichtung besser ausgeleuchtet wird, sondern es soll auch die jeweilige Lichtverteilung verschiedenen Umgebungsbedingungen angepasst werden können.

Eine Anordnung von fest installierten Leuchtdioden ermöglicht es, ein AFS ohne bewegliche Komponenten zu konstruieren. Hierzu werden die Leuchtdioden einzeln oder gruppenweise ein- oder ausgeschaltet. Dabei tritt jedoch das Problem auf, dass es bei direkter Projektion der Leuchtdioden zur Abbildung der einzelnen Lichtquellen und der dunkleren Zwischenräume kommt, so dass keine homogene Ausleuchtung erreicht wird. Das ist insbesondere bei vorgesehenen Anwendungen in Scheinwerfern störend.

Die Druckschriften US 2004/179368 A1, US 2006/022211 A1, US 2005/157508 A1, DE 20 2007 00148 U1 und DE 100 44 455 A1 beschreiben jeweils Beleuchtungseinrichtungen mit Leuchtdioden als Lichtquellen.

Aufgabe der vorliegenden Erfindung ist es, eine Lichtquelle mit veränderlicher Abstrahlcharakteristik anzugeben, die insbesondere für AFS geeignet ist und mit der eine weitgehend homogene Ausleuchtung mit möglichst geringem technischem Aufwand erreicht wird.

Diese Aufgabe wird mit der Lichtquelle mit den Merkmalen des Anspruches 1 gelöst. Ausgestaltungen ergeben sich aus den abhängigen Ansprüchen.

Die Lichtquelle umfasst eine Anordnung von Leuchtdioden in der Form montierter LED-Chips und eine Schaltung, mit der die Leuchtdioden einzeln oder in Gruppen eingeschaltet und ausgeschaltet werden. Es ist eine Vorrichtung zur Homogenisierung des ausgesandten Lichtstrahles vorhanden, mit der eine weitgehend gleichmäßige und/oder sich räumlich stetig ändernde Beleuchtung eines beleuchteten Objektes, zum Beispiel der Fahrbahn, erreicht wird. Bei den bevorzugten Ausgestaltungen umfasst diese Vorrichtung als wesentliche Komponente eine Konversionsplatte, eine Vergussmasse oder eine Anordnung von Mikrooptiken. Auch eine Kombination von zwei oder drei dieser Komponenten ist dabei möglich.

Es folgt eine genauere Beschreibung von Beispielen der Vorrichtung anhand der beigefügten Figuren.
Die Figur 1 zeigt ein Ausführungsbeispiel einer Anordnung von LED-Chips in einem Gehäuse.
Die Figur 2 zeigt das Gehäuse gemäß der Figur 1 mit einer oberseitig aufgebrachten Konversionsplatte.
Die Figur 3 zeigt einen Querschnitt durch das Gehäuse gemäß der Figur 2 in einer anderen Blickrichtung.
Die Figur 4 zeigt ein weiteres Ausführungsbeispiel einer Anordnung von LED-Chips in einem Gehäuse.
Die Figur 5 zeigt eine Aufsicht auf die Anordnung gemäß der Figur 4.
Die Figur 6 zeigt das Gehäuse gemäß der Figur 4 aus einer anderen Blickrichtung.
Die Figur 7 zeigt eine Anordnung eines LED-Chips und einer Vorrichtung zur Strahlformung.
Die Figur 8 zeigt eine Anordnung gemäß der Figur 7 für ein weiteres Ausführungsbeispiel.
Die Figur 9 zeigt eine Anordnung aus mehreren Anordnungen gemäß der Figur 7.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Bei einem Ausführungsbeispiel der Lichtquelle wird eine Anordnung von LED-Chips, in denen lichtemittierende Dioden integriert sind, mit einer Platte versehen, im Folgenden als Konversionsplatte bezeichnet, die in der Richtung der Abstrahlung des ausgesandten Lichtstrahls angeordnet ist und eine Homogenisierung des Lichtstrahls bewirkt. Die Konversionsplatte kann zum Beispiel eine Platte aus Glas oder transparentem Kunststoff sein, die mit einer Beschichtung aus einem Material versehen ist, das die vorgesehene Homogenisierung des Lichtstrahls bewirkt. Die Strahlformung kann auch mit einem in das Material der Platte eingemischten Material bewirkt sein. Es kann je nach der vorgesehenen Anwendung der Lichtquelle genügen, wenn in das Material der Beschichtung beziehungsweise in das Glas oder den Kunststoff der Platte kleine Partikel eingemischt sind, die eine Streuung des hindurchtretenden Lichtes verursachen und so zu einer gleichmäßigeren Verteilung der Lichtabstrahlung führen. Es kann stattdessen oder zusätzlich in der Beschichtung beziehungsweise in der Platte ein Konvertermaterial vorhanden sein, mit dem die Wellenlänge und/oder die Bandbreite des Spektrums des abgestrahlten Lichtes verändert wird.

Wesentlich ist hierbei, dass die Lichtabstrahlung nicht durch eine vollständig lichtdurchlässige Abdeckung hindurch erfolgt, sondern durch eine Konversionsplatte, die in der oben beschriebenen Weise die vorgesehene gleichmäßigere Verteilung der Lichtabstrahlung bewirkt. Damit ist es insbesondere auch möglich, zu erreichen, dass die Lichtabstrahlung von der Strahlmitte zu den Seiten hin kontinuierlich schwächer wird. Eine solche mit einem Auslauf versehene Verteilung der Lichtabstrahlung kann insbesondere für vorgesehene Anwendungen bei Scheinwerfern von Vorteil sein.

Für jeden in der Anordnung eingesetzten LED-Chip kann eine Teilplatte der Konversionsplatte vorgesehen sein. An den Rändern dieser Teilplatten können Beschichtungen vorhanden sein, die für das abzustrahlende Licht zumindest weitgehend undurchlässig sind. Damit wird erreicht, dass das abgestrahlte Licht nicht innerhalb der Konversionsplatte gestreut wird und dass das von einem jeweiligen LED-Chip ausgehende Licht nur im Bereich der zugeordneten Teilplatte abgestrahlt wird. Eine lichtundurchlässige randseitige Beschichtung kann auch auf einen äußeren Rand der Konversionsplatte beschränkt sein. Die Anordnung von LED-Chips ist besonders zweckmäßig in einem Gehäuse montiert, das einzelne Abteilungen für jeweils eine Leuchtdiode aufweist.

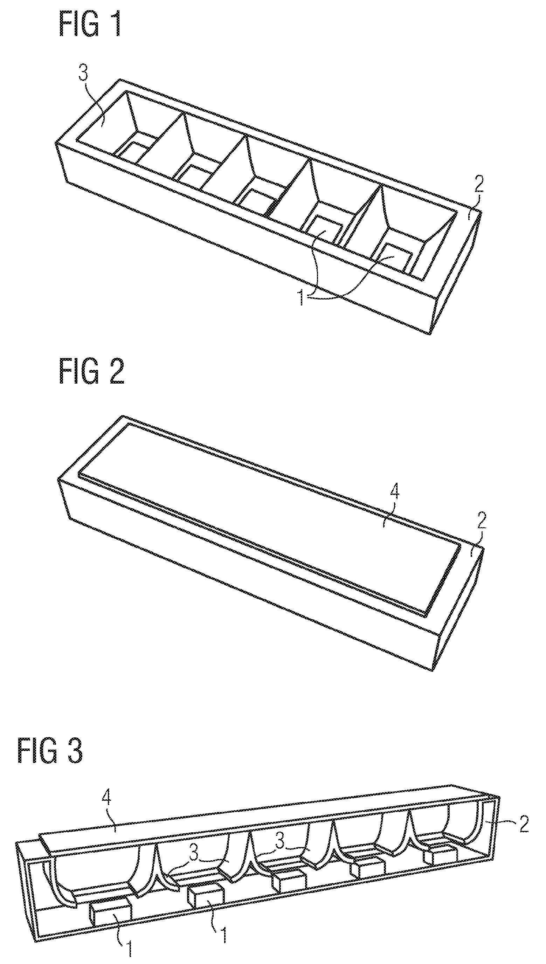

Die Figur 1 zeigt eine schräge Aufsicht auf eine Anordnung von LED-Chips 1 in Abteilungen eines Gehäuses 2, das vorzugsweise lichtundurchlässig ist und in der vorgesehenen Richtung der Lichtabstrahlung offen ist. Trennwände zwischen den Abteilungen können, wie das in der Figur 1 dargestellt ist, durch Kollimationsvorrichtungen 3 gebildet sein, mit denen das jeweils von einem LED-Chip ausgesandte Licht gebündelt wird. Bei den Kollimationsvorrichtungen 3 handelt es sich in dem in der Figur 1 gezeigten Ausführungsbeispiel um reflektierende Flächen, die so gewölbt sind, dass das abgestrahlte Licht gebündelt wird. Die reflektierenden Flächen können zu diesem Zweck zum Beispiel einen zumindest näherungsweise parabolischen Querschnitt aufweisen. In der Figur 1 ist die Anordnung oberseitig offen dargestellt.

Die Figur 2 zeigt das Gehäuse 2 gemäß der Figur 1 mit einer darauf aufgebrachten Konversionsplatte 4. Die Abteilungen des Gehäuses und die darin vorhandenen LED-Chips sind in der Figur 2 nicht erkennbar, womit angedeutet wird, dass die Konversionsplatte 4 nicht vollständig klar und lichtdurchlässig ist; das soll andererseits nicht so verstanden werden, dass die Konversionsplatte 4 lichtundurchlässig wäre. Aufgrund der optischen Eigenschaften der Konversionsplatte 4 wird die vorgesehene Homogenisierung des ausgesandten Lichtstrahls bewirkt. Da die gesamte Oberseite des Gehäuses mit der Konversionsplatte 4 versehen ist, wird der ausgesandte Lichtstrahl wirksam homogenisiert, unabhängig davon, welche der LED-Chips eingeschaltet sind. In unterschiedlichen Betriebszuständen wird damit auf einfache Weise immer eine räumlich gleichmäßige oder kontinuierlich veränderte Lichtabstrahlung bewirkt.

Die Figur 3 zeigt einen Querschnitt durch die Anordnung der Figur 2 aus einer seitlichen Blickrichtung. Es sind hier deutlich die parabolisch gewölbten Kollimationsvorrichtungen 3 über den jeweiligen LED-Chips 1 erkennbar. Auf der Oberseite des Gehäuses 2 ist die Konversionsplatte 4 zur besseren Übersichtlichkeit der Zeichnung als einzelne durchgehende Platte dargestellt. Wie bereits erwähnt, kann die Konversionsplatte aber auch aus Teilplatten zusammengesetzt sein, die jeweils einem LED-Chip zugeordnet sind und jeweils etwa denjenigen Bereich der Gehäuseöffnung abdecken, durch den das Licht der betreffenden Leuchtdiode abgestrahlt wird. Je nach dem Grad der Lichtdurchlässigkeit erzeugt die Konversionsplatte eine vorgesehene Abstrahlcharakteristik einer homogen leuchtenden Fläche, deren Lichtabstrahlung über eine weitere optische Vorrichtung in einer gewünschten Weise projiziert werden kann. Die Lichtverteilung wird durch das Zu- und Abschalten der LED-Chips verändert. Die Anordnung der Leuchtdioden kann entsprechend den jeweils vorgesehenen Anwendungen gewählt werden, und das Gehäuse kann entsprechend vielfältige Formen aufweisen, insbesondere kann es auch gewölbt sein.

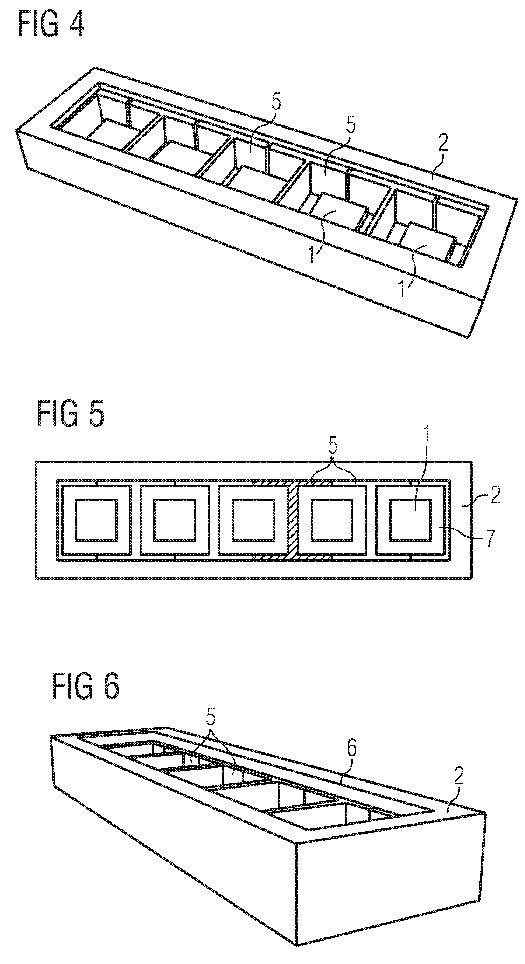

Die Figur 4 zeigt ein weiteres Ausführungsbeispiel einer Anordnung von LED-Chips 1 in einem Gehäuse 2, das vorzugsweise lichtundurchlässig ist und in der vorgesehenen Richtung der Lichtabstrahlung offen ist. Zwischen den LED-Chips sind Trennwände 5 vorhanden, die zum Beispiel aus Glas sein können und eine typische Dicke von wenigstens 25 µm und höchstens 75 µm, etwa 50 µm aufweisen können. Die Trennwände können für das abgestrahlte Licht undurchlässig und vorzugsweise diffus reflektierend sein. Innerhalb des Gehäuses 2 ist eine Vergussmasse 7 vorgesehen, die mit einem Konvertermaterial oder mit Streupartikeln versehen ist. Die Vergussmasse 7 ist daher nicht vollständig klar und lichtdurchlässig, sondern bewirkt eine Homogenisierung des ausgesandten Lichtstrahls. Durch ein Konvertermaterial in der Vergussmasse kann auch entsprechend der für die Lichtquelle vorgesehenen Anwendung die Wellenlänge oder die Bandbreite des Spektrums des von den Leuchtdioden erzeugten Lichtes verändert werden. Es kann stattdessen genügen, wenn mit in der Vergussmasse verteilten kleinen Streupartikeln eine Diffusion des Lichtes erreicht wird. Die Verteilung der Lichtabstrahlung kann auch bei diesem Ausführungsbeispiel durch einfaches Zu- und Abschalten der Leuchtdioden in den LED-Chips verändert werden. Lichtundurchlässige Trennwände 5 bewirken, dass sich das Licht nicht quer zur Abstrahlrichtung in der Vergussmasse ausbreitet. Dadurch wird die durch das Ein- und Ausschalten der LED-Chips vorgesehene Veränderung der Lichtabstrahlung wirkungsvoll erreicht, und die Abstrahlcharakteristik wird nicht durch eine Lichtausbreitung innerhalb des Gehäuses beeinträchtigt.

Die Figur 5 zeigt die Anordnung gemäß der Figur 4 in einer Aufsicht, in der die LED-Chips 1 als Beispiel mit einer quadratischen Lichtabstrahlfläche dargestellt sind und in der die Elemente, aus denen die Trennwände 5 gebildet sind, gut erkennbar sind. Die Trennwände sind hier durch einzelne, in der Aufsicht H-förmige Elemente gebildet; sie können aber auch aus einem Stück gebildet, mit dem Gehäuse 2 verbunden oder integraler Bestandteil des Gehäuses 2 sein.

In der Figur 6 ist in einer schrägen Aufsicht auf die Anordnung gemäß der Figur 4 aus einem anderen Blickwinkel deutlich erkennbar, dass es bei diesem Ausführungsbeispiel von Vorteil sein kann, wenn die Gehäuseränder 6 etwas höher sind als die oberen Ränder der Trennwände 5. Die Vergussmasse 7 kann in diesem Fall innerhalb des Gehäuses 2 auch oberhalb der Trennwände 5 vorhanden sein und die Trennwände oberseitig überdecken. Auf diese Weise wird eine ausreichende Homogenisierung des ausgesandten Lichtstrahles auch im Bereich der Trennwände erreicht. Die hierfür vorzusehenden relativen Abmessungen des Innenvolumens des Gehäuses und der Trennwände können entsprechend der jeweiligen Ausgestaltung und dem gewünschten Grad an Homogenisierung des Lichtstrahles gewählt werden. Die Anordnung der Leuchtdioden kann auch bei diesem Ausführungsbeispiel entsprechend den jeweils vorgesehenen Anwendungen gewählt werden, und das Gehäuse kann entsprechend vielfältige Formen aufweisen, insbesondere kann es auch gewölbt sein.

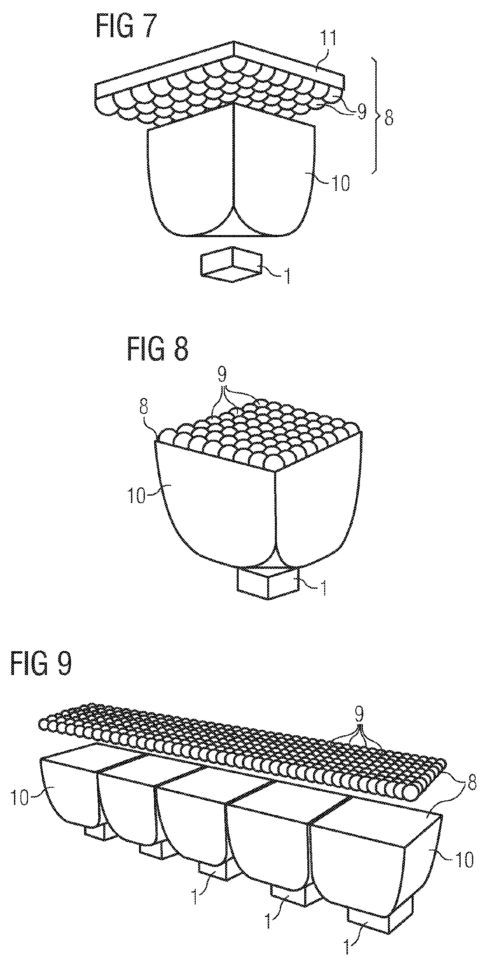

Ein weiteres Ausführungsbeispiel ist in den Figuren 7 bis 9 dargestellt. Hierbei wird gemäß der in der Figur 7 gezeigten Anordnung einem jeweiligen LED-Chip 1 eine Vorrichtung 8 zur Strahlformung zugeordnet, die bei dem dargestellten Ausführungsbeispiel eine Platte 11 mit Mikrooptiken 9 und eine kollimierende optische Vorrichtung 10 als Primäroptik umfasst. Der wesentliche Bestandteil ist hierbei die Anordnung der Mikrooptiken 9, die zum Beispiel kleine Linsen sein können. Durch die Mikrooptiken 9 wird die Strahlformung entsprechend der gewünschten Lichtverteilung bewirkt. Das ermöglicht jede gewünschte Abstrahlcharakteristik in einen Raumwinkel, der größer ist als der Raumwinkel des durch die kollimierende optische Vorrichtung 10 vorkollimierten Strahles.

Während bei dem Ausführungsbeispiel gemäß der Figur 7 die Mikrooptiken 9 auf einer lichtdurchlässigen Platte 11 angeordnet sind, können die Mikrooptiken auch gemäß der Figur 8 bereits in einer kollimierenden optischen Vorrichtung 10 integriert sein. In den Figuren 7 und 8 ist erkennbar, dass die kollimierende optische Vorrichtung 10, die hier als Primäroptik zur Strahlbündelung eingesetzt wird, gewölbte reflektierende Seitenflächen aufweisen kann, die beispielsweise einen im Wesentlichen parabolischen Querschnitt besitzen. Es kann sich auch um einen Parabolreflektor mit runder Austrittsfläche handeln. Die reflektierenden Flächen sind in diesem Fall in der von Scheinwerfern an sich bekannten Weise durch ein Rotationsparaboloid gebildet.

Mehrere Anordnungen gemäß den Figuren 7 oder 8 können zum Beispiel gemäß der Figur 9 in einer gemeinsamen Anordnung mehrerer LED-Chips zusammengefasst werden, so dass auch hiermit durch einfaches Ein- und Ausschalten der LED-Chips einzeln oder in Gruppen die Lichtverteilung wie vorgesehen verändert werden kann. Der ausgesandte Lichtstrahl wird jeweils durch die Vorrichtung 8 zur Strahlformung homogenisiert, so dass auch bei diesem Ausführungsbeispiel die Abstrahlcharakteristik ohne Verwendung mechanischer Komponenten verändert werden kann und gleichzeitig eine ausreichende Homogenisierung des ausgesandten Lichtstrahles in jedem Betriebszustand der Anordnung erreicht wird.

Die als Beispiele dargestellten Komponenten der verschiedenen Ausführungsbeispiele können auch miteinander kombiniert werden. Insbesondere kann die Anordnung gemäß der Figur 9 in einem Gehäuse entsprechend den Ausführungsbeispielen der Figuren 1 oder 4 angebracht sein. Die kollimierenden optischen Vorrichtungen 10 können dann zum Beispiel durch die Kollimationsvorrichtungen 3 in der Gehäuseform der Figur 1 gebildet sein. Die Konversionsplatte 4 ist in einem derartigen weiteren Ausführungsbeispiel durch die Anordnung der Mikrooptiken 9, die in der Figur 9 dargestellt ist, ersetzt.

Für die Projektion des homogenisierten Lichtstrahles kann eine Sekundäroptik vorgesehen werden, die zum Beispiel eine Projektionslinse und/oder ein Reflektorsystem umfassen kann. Bei Anwendungen der Ausführungsbeispiele gemäß den Figuren 1 bis 6 ist die Verwendung einer solchen Sekundäroptik in der Regel vorteilhaft oder sogar erforderlich, während bei den Ausführungsbeispielen gemäß den Figuren 7 bis 9 auf weitere optische Vorrichtungen verzichtet werden kann. Eine ausreichend gute Projektion des Lichtstrahles auf das zu beleuchtende Objekt wird bereits durch die Ausgestaltung der Mikrooptiken 9 sichergestellt.

Diese Patentanmeldung beansprucht die Priorität der deutschen Patentanmeldung 10 2007 046 339.3, deren Offenbarungsgehalt hiermit durch Rückbezug aufgenommen wird.

## Patentansprüche

1. Lichtquelle, bei der
- eine Anordnung von LED-Chips (1) vorhanden ist,
- eine Schaltung vorgesehen ist, mit der diese LED-Chips (1) einzeln oder in Gruppen eingeschaltet und ausgeschaltet werden können, und
- eine Vorrichtung (4; 7; 8) zur Homogenisierung eines von eingeschalteten LED-Chips (1) ausgesandten Lichtstrahls vorhanden ist, wobei die Vorrichtung zumindest eine der folgenden Komponenten umfasst: eine Konversionsplatte (4) und/oder eine Vergussmasse (7) mit einem Konvertermaterial und/oder mit Streupartikeln,
- ein Gehäuse (2) mit Abteilungen vorhanden ist, das auf einer für Lichtabstrahlung vorgesehenen Seite offen ist,
- die LED-Chips (1) in den Abteilungen des Gehäuses (2) angeordnet sind,
**dadurch gekennzeichnet, dass**
- die Abteilungen des Gehäuses (2) mit Kollimationsvorrichtungen (3) versehen sind, mit denen das jeweils von einem LED-Chip (1) ausgesandte Licht gebündelt wird, und die für Lichtabstrahlung vorgesehene Seite des Gehäuses (2) mit der Konversionsplatte (4) versehen ist und
- die Abteilungen des Gehäuses (2) mit Trennwänden (5) versehen sind, die für das abgestrahlte Licht undurchlässig oder zumindest nicht vollständig durchlässig sind und das Gehäuse (2) mit der Vergussmasse (7) gefüllt ist.

2. Lichtquelle nach dem vorherigen Anspruch, bei der
- die Konversionsplatte (4) in Teilplatten mit Rändern unterteilt ist,
- jede Teilplatte einem LED-Chip (1) zugeordnet ist und
- die Ränder der Teilplatten mit lichtundurchlässigen Beschichtungen versehen sind.

3. Lichtquelle nach einem der vorherigen Ansprüche,
bei der die Konversionsplatte (4) eine transparente Platte mit einer Beschichtung aus einem Konvertermaterial ist.

4. Lichtquelle nach einem der vorherigen Ansprüche,
bei der die Konversionsplatte (4) aus einem Material gebildet ist, das ein Konvertermaterial umfasst.

5. Lichtquelle nach einem der vorherigen Ansprüche,
bei der die Konversionsplatte (4) ein lichtdurchlässiges Material umfasst, in dem Streupartikel verteilt sind.

6. Lichtquelle nach dem vorherigen Anspruch,
bei der
- auf der für Lichtabstrahlung vorgesehenen Seite des Gehäuses (2) ein Gehäuserand (6) vorhanden ist, der die Trennwände (5) überragt, und
- die Vergussmasse (7) innerhalb des Gehäuses (2) auch oberhalb der Trennwände (5) vorhanden ist und die Trennwände (5) überdeckt.

7. Lichtquelle nach einem der vorherigen Ansprüche,
bei der die Trennwände (5) Glas sind.

8. Lichtquelle nach einem der vorherigen Ansprüche,
bei der die Trennwände (5) für das abgestrahlte Licht undurchlässig sind.

9. Lichtquelle nach einem der vorherigen Ansprüche,
bei der die Trennwände (5) für das abgestrahlte Licht diffus reflektierend sind.

10. Lichtquelle nach Anspruch 1,
bei der eine Vorrichtung (8) zur Strahlformung mit einer Mehrzahl von Mikrooptiken (9) vorhanden ist, wobei die Mikrooptiken (9) Linsen sind.

11. Lichtquelle nach einem der vorherigen Ansprüche,
bei der die Vorrichtung (8) zur Strahlformung kollimierende optische Vorrichtungen (10) umfasst, die jeweils zwischen einem LED-Chip (1) und einem Anteil der Mikrooptiken (9) angeordnet sind.

## Claims

1. Light source wherein
- an arrangement of LED chips (1) is present,
- a circuit is provided, by means of which said LED chips (1) can be switched on and switched off individually or in groups, and
- a device (4; 7; 8) for homogenizing a light beam emitted by switched-on LED chips (1) is present, wherein the device comprises at least one of the following components: a conversion plate (4) and/or a potting compound (7) comprising a converter material and/or comprising scattering particles,
- a housing (2) having compartments is present, which is open on a side provided for light emission,
- the LED chips (1) are arranged in the compartments of the housing (2),
**characterized in that**
- the compartments of the housing (2) are provided with collimation devices (3), by means of which the light respectively emitted by an LED chip (1) is concentrated, and that side of the housing (2) which is provided for light emission is provided with the conversion plate (4), and
- the compartments of the housing (2) are provided with partition walls (5) which are non-transmissive or at least not completely transmissive to the emitted light and the housing (2) is filled with the potting compound (7).

2. Light source according to the preceding claim, wherein
- the conversion plate (4) is subdivided into partial plates having edges,
- each partial plate is assigned to a LED chip (1), and
- the edges of the partial plates are provided with light-non-transmissive coatings.

3. Light source according to either of the preceding claims,
wherein the conversion plate (4) is a transparent plate having a coating composed of a converter material.

4. Light source according to any of the preceding claims,
wherein the conversion plate (4) is formed from a material comprising a converter material.

5. Light source according to any of the preceding claims,
wherein the conversion plate (4) comprises a light-transmissive material in which scattering particles are distributed.

6. Light source according to the preceding claim, wherein
- a housing edge (6) that projects beyond the partition walls (5) is present on that side of the housing (2) which is provided for light emission, and
- the potting compound (7) is present within the housing (2) also above the partition walls (5) and covers the partition walls (5).

7. Light source according to any of the preceding claims,
wherein the partition walls (5) are glass.

8. Light source according to any of the preceding claims,
wherein the partition walls (5) are non-transmissive to the emitted light.

9. Light source according to any of the preceding claims,
wherein the partition walls (5) are diffusely reflective to the emitted light.

10. Light source according to Claim 1,
wherein a device (8) for beam shaping comprising a plurality of micro-optical units (9) is present, wherein the micro-optical units (9) are lenses.

11. Light source according to any of the preceding claims,
wherein the device (8) for beam shaping comprises collimating optical devices (10) arranged in each case between a LED chip (1) and a portion of the micro-optical units (9).

## Revendications

1. Source de lumière, dans laquelle
- un arrangement de puces de LED (1) est présent,
- il existe un circuit qui permet de mettre en circuit et hors circuit ces puces de LED (1) individuellement ou en groupes, et
- un dispositif (4; 7; 8) d'homogénéisation d'un rayon lumineux émis par les puces de LED (1) mises en circuit est présent, le dispositif comprenant au moins l'un des composants suivants : une plaque de conversion (4) et/ou une masse de scellement (7) avec un matériau convertisseur et/ou avec des particules de dispersion,
- un boîtier (2) muni de divisions est présent, lequel est ouvert d'un côté destiné au rayonnement de lumière,
- les puces de LED (1) sont disposées dans les divisions du boîtier (2),
**caractérisée en ce que**
- les divisions du boîtier (2) sont pourvues de dispositifs collimateurs (3) avec lesquels la lumière respectivement émise par une puce de LED (1) est mise en faisceau, et le côté du boîtier (2) destiné au rayonnement de lumière est muni de la plaque de conversion (4) et
- les divisions du boîtier (2) sont pourvues de parois de séparation (5) qui sont opaques ou au moins pas entièrement transparentes pour la lumière rayonnée et le boîtier (2) est rempli de la masse de scellement (7).

2. Source de lumière selon la revendication précédente, dans laquelle
- la plaque de conversion (4) est divisée en plaques partielles munies de bords,
- une puce de LED (1) est associée à chaque plaque partielle et
- les bords des plaques partielles sont munis de revêtements opaques.

3. Source de lumière selon l'une des revendications précédentes, dans laquelle la plaque de conversion (4) est une plaque transparente munie d'un revêtement en un matériau de conversion.

4. Source de lumière selon l'une des revendications précédentes, dans laquelle la plaque de conversion (4) est constituée d'un matériau qui comprend un matériau de conversion.

5. Source de lumière selon l'une des revendications précédentes, dans laquelle la plaque de conversion (4) comprend un matériau transparent dans lequel sont distribuées des particules de dispersion.

6. Source de lumière selon la revendication précédente, dans laquelle
- un bord de boîtier (6) est présent sur le côté du boîtier (2) qui est conçu pour le rayonnement de lumière, lequel fait saillie au-dessus des parois de séparation (5), et
- la masse de scellement (7) à l'intérieur du boîtier (2) est également présente au-dessus des parois de séparation (5) et recouvre les parois de séparation (5).

7. Source de lumière selon l'une des revendications précédentes, dans laquelle les parois de séparation (5) sont en verre.

8. Source de lumière selon l'une des revendications précédentes, dans laquelle les parois de séparation (5) sont opaques pour la lumière rayonnée.

9. Source de lumière selon l'une des revendications précédentes, dans laquelle les parois de séparation (5) sont réfléchissantes de manière diffuse pour la lumière rayonnée.

10. Source de lumière selon la revendication 1, dans laquelle un dispositif (8) de formage du rayon muni d'une pluralité de micro-optiques (9) est présent, les micro-optiques (9) étant des lentilles.

11. Source de lumière selon l'une des revendications précédentes, dans laquelle le dispositif (8) de formage du rayon comprend des dispositifs optiques de collimation (10) qui sont respectivement disposés entre une puce de LED (1) et une portion des micro-optiques (9).
